# EUROPÄISCHE PATENTANMELDUNG

(11) **EP 4 462 148 A1**
(43) Veröffentlichungstag der Anmeldung: **13.11.2024**
(21) Anmeldenummer: 24170259.6
(22) Anmeldetag: 15.04.2024
(51) Int. Cl.: G01R 35/00

(54) **VERFAHREN UND VORRICHTUNG ZUR BESTIMMUNG MINDESTENS EINES KORREKTURPARAMETERS FÜR MINDESTENS EINE TEMPERATURABHÄNGIGE EIGENSCHAFT EINES ELEKTRISCHEN BAUELEMENTS**

(30) Priorität: 04.05.2023 DE 102023204164
(71) Anmelder: VOLKSWAGEN AG, 38440 Wolfsburg (DE)
(72) Erfinder: Kube, Adrian, 91097 Oberreichenbach (DE)

(57) **Zusammenfassung**

Die Erfindung betrifft ein Verfahren und eine Vorrichtung zur Bestimmung mindestens eines Korrekturparameters (P, P1) für mindestens eine temperaturabhängige Eigenschaft mindestens eines ersten elektrischen Bauelements (B1), welches in einem mehrschrittigen Produktionsverfahren eines Produkts verbaut wird, wobei in zumindest einem ersten Produktionsschritt des Produktionsverfahrens eine Temperatur des ersten elektrischen Bauelements (B1) auf eine erste Produktionstemperatur verändert wird, umfassend mindestens:
- Bestimmen der mindestens einen Eigenschaft des ersten elektrischen Bauelements (B1) nach Erreichen der ersten Produktionstemperatur als erste temperaturspezifische Eigenschaft (ET1, B1_ET1) des ersten elektrischen Bauelements (B1),
- Bestimmen der mindestens einen Eigenschaft des ersten elektrischen Bauelements (B1) bei mindestens einer weiteren Produktionstemperatur, die von der ersten Produktionstemperatur verschieden ist, als weitere temperaturspezifische Eigenschaft (ETW, B1_ETW) des ersten elektrischen Bauelements (B1),

Bestimmen des mindestens einen Korrekturparameters (P, P1) in Abhängigkeit der temperaturspezifischen Eigenschaften (ET1, B1_ET1, ETW, B1_ETW) des ersten elektrischen Bauelements (B1).

## Beschreibung

Die Erfindung betrifft ein Verfahren und eine Vorrichtung zur Bestimmung mindestens eines Korrekturparameters für mindestens eine temperaturabhängige Eigenschaft mindestens eines elektrischen Bauelements.

In Traktionsnetzen von elektrischen Fahrzeugen, insbesondere elektrischen Straßen- oder Schienenfahrzeugen, aber auch bei anderen Anwendungen, ist die Messung der Hochvolt-Gleichspannung, der Phasenströme, die von Wechselrichtern erzeugt werden, und/oder einer Rotorspannung einer elektrischen Antriebsmaschine für die Bestimmung der aktuell bereitgestellten/verbrauchten Leistung notwendig. Zur Messung der Hochvolt-Gleichspannung werden Widerstandselemente mit sehr geringen Toleranzen in Widerstandsteilern eingesetzt. Auch bei der Phasenstrommessung werden solche Widerstandselemente eingesetzt, genauso wie bei der Messung einer Rotorspannung. Beispielhaft können diese Toleranzen 0,1 % des Nominalwerts betragen. Widerstände mit einer solch geringen Toleranz weisen in der Regel auch eine geringe Änderung des Widerstandswertes über verschiedene Temperaturen auf. Vorstellbar ist, dass Widerstandselemente mit einer Toleranz von 0,1 % des Nominalwerts (Grundwerts) über den gesamten Temperaturbereich und die gesamte Lebensdauer maximal eine Toleranz von 2 % des Nominalwerts aufweisen. Widerstände mit höhere Toleranzen, beispielsweise mit einer Toleranzen von 1 % des Nominalwerts, erreichen üblicherweise über den gesamten Temperaturbereich und die gesamte Lebensdauer nur Toleranzen größer als 2 %. Nachteilig ist, dass elektrische Bauelemente mit geringen Toleranzen in der Regel teuer und schwer verfügbar sind. Es ist wünschenswert, die Genauigkeit bei der Bestimmung von Widerstandswerten für verschiedene Temperaturen zu verbessern, um z.B. einen genauere Strom- oder Spannungsmessung zu ermöglichen. Es ist bekannt, bei Widerstandselementen auf einer Leiterplatte einen so genannten End-of-Line-Test durchzuführen, bei dem ein Widerstandswert in einem sogenannten Bandende-Test (End-of-Line-Test) bestimmt wird, um eine Einpunktkalibrierung durchzuführen. Eine solche Kalibrierung ist jedoch oftmals nicht hinreichend genau.

Es stellt sich das technische Problem, ein Verfahren und eine Vorrichtung zur Bestimmung mindestens eines Korrekturparameters für mindestens eine temperaturabhängige Eigenschaft mindestens eines elektrischen Bauelements zu schaffen, die eine möglichst genaue und einfach implementierbare, insbesondere in bestehende Produktionsverfahren einfach integrierbare, Bestimmung ermöglichen.

Die Lösung des technischen Problems ergibt sich durch die Gegenstände mit den Merkmalen der unabhängigen Ansprüche. Weitere vorteilhafte Ausgestaltungen ergeben sich aus den Unteransprüchen.

Vorgeschlagen wird ein Verfahren zur Bestimmung mindestens eines Korrekturparameters für mindestens eine temperaturabhängige Eigenschaft mindestens eines ersten elektrischen Bauelements. Das Verfahren kann Teil eines Kalibrierverfahrens sein und der Korrekturparameter kann auch als Kalibrierparameter bezeichnet werden. Der mindestens eine Korrekturparameter ermöglicht insbesondere, für verschiedene Temperaturen einen temperaturspezifischen Ist-Wert der Eigenschaft zu bestimmen. Die Bestimmung kann weiter in Abhängigkeit eines Nominalwerts bestimmt werden, der bei einer Referenztemperatur vorliegt. Ein elektrisches Bauelement kann auch ein elektronisches Bauelement sein. Beispielhafte elektrische Bauelemente sind, nicht abschließend, resistive Elemente wie z.B. Widerstandselemente, kapazitive Elemente wie z.B. Kondensatoren und induktive Elemente wie z.B. Spulen, Halbleiterelemente.

Das elektrische Bauelement wird in einem mehrschrittigen Produktionsverfahren eines Produkts verbaut. Dies kann bedeuten, dass das elektrische Bauelement in oder an dem Produkt angeordnet wird. Im fertiggestellten Zustand kann das elektrische Bauelement ein Bestandteil, insbesondere integraler Bestandteil, des Produkts sein. Das Produktionsverfahren umfasst hierbei mehrere Produktionsschritte, wobei ein Produktionsschritt ein zur Herstellung des fertiggestellten Zustands benötigter Schritt ist. Ein solcher Produktionsschritt kann beispielsweise ein Montage- oder ein Befestigungsschritt zur Montage bzw. Befestigung des ersten elektrischen Bauelements sein. Ein Produktionsschritt ist kein Testschritt zum Testen einer Funktionsfähigkeit eines Bauelements oder des Produkts.

In zumindest einem ersten Produktionsschritts des Produktionsverfahrens wird eine Temperatur des ersten elektrischen Bauelements auf eine erste Produktionstemperatur verändert, insbesondere von einer Ausgangstemperatur, die eine Umgebungstemperatur sein kann. Die Veränderung der Produktionstemperatur erfolgt hierbei im Rahmen der Durchführung des Produktionsschrittes, also um den fertiggestellten Zustand herzustellen. Der erste Produktionsschritt bezeichnet hierbei nicht notwendiger Weise den ersten Produktionsschritts des Produktionsverfahrens, sondern einen beliebigen Produktionsschritt. Die Veränderung auf diese Produktionstemperatur kann eine aktive Veränderung sein, wobei hierzu aktiv, also unter Energieverbrauch, thermische Energie zu- bzw. abgeführt wird. Die Veränderung kann aber auch eine passive Veränderung sein, wobei ohne Energieverbrauch, thermische Energie zu- bzw. abgeführt wird. Dies kann z.B. bei einem Abkühlen auf Umgebungstemperatur erfolgen.

Weiter umfasst das Verfahren ein Bestimmen der mindestens einen Eigenschaft des ersten elektrischen Bauelements nach Erreichen der ersten Produktionstemperatur als erste temperaturspezifische Eigenschaft des ersten elektrischen Bauelements. Die Eigenschaft kann hierbei insbesondere gemessen, also sensorgestützt, erfasst werden. Selbstverständlich umfasst das Bestimmen aber auch ein rechnerisches Bestimmen in Abhängigkeit von sensorgestützt erfassten anderen Eigenschaften. Die erste temperaturspezifische Eigenschaft kann gespeichert werden, insbesondere in einer Speichereinrichtung. Diese kann eine lokale Speichereinrichtung einer Auswerteeinrichtung sein, wobei die Auswerteeinrichtung wiederum Teil einer Steuereinrichtung des Produktionsverfahrens sein kann. Eine Auswerte- bzw. Steuereinrichtung kann eine Recheneinrichtung sein. Eine Recheneinrichtung kann einen Mikrocontroller oder eine integrierte Schaltung umfassen oder als solche(r) ausgebildet sein kann.

Weiter umfasst das Verfahren ein Bestimmen der mindestens einen Eigenschaft des elektrischen Bauelements bei mindestens einer weiteren Produktionstemperatur, die von der ersten Produktionstemperatur verschieden ist, als weitere temperaturspezifische Eigenschaft des ersten elektrischen Bauelements. Auch diese weitere temperaturspezifische Eigenschaft kann gespeichert werden. Eine weitere Produktionstemperatur bezeichnet eine Temperatur, die sich zwischen verschiedenen Produktionsschritten oder während der Durchführung eines weiteren Produktionsschritts, der vom ersten Produktionsschritt verschieden ist, einstellt. Das Bestimmen der weiteren temperaturspezifischen Eigenschaft des ersten elektrischen Bauelements kann im Produktionsverfahren zeitlich vor oder zeitlich nach dem Bestimmen der ersten temperaturspezifischen Eigenschaft des ersten elektrischen Bauelements erfolgen.

Die weitere Produktionstemperatur kann insbesondere ein Bandende-Temperatur sein, die sich nach der Durchführung des letzten Produktionsschritts einstellt. Diese kann eine Umgebungstemperatur sein. Insbesondere kann diese Bandende-Temperatur auch eine Testtemperatur bei einem Bandende-Test sein, wobei in diesem Test eine Funktionsfähigkeit des Produkts und/oder von Bauelementen des Produkts getestet wird.

Weiter erfolgt ein Bestimmen des mindestens einen Korrekturparameters. Somit wird also der mindestens eine Korrekturparameter in Abhängigkeit von mindestens zwei temperaturspezifischen Eigenschaften, die insbesondere voneinander verschieden sein können, bestimmt. Beispielsweise kann als Korrekturparameter ein Offset-Wert der mindestens einen Eigenschaft oder ein Korrekturwert für einen vorbekannten Soll-Offset-Wert der mindestens einen Eigenschaft bestimmt werden. Auch kann ein Steigungswert oder ein Korrekturwert für einen vorbekannten Soll-Steigungswert bestimmt werden, wobei die Steigung ein Maß der Änderung der mindestens einen Eigenschaft bei einer vorbestimmten Temperaturänderung angibt.

Weiter kann ein Eigenschaftskorrekturfaktor bestimmt werden, der die Bestimmung der temperaturspezifischen Eigenschaft bezogen auf eine vorbestimmte Referenztemperatur ermöglicht. Dies kann z.B. gewünscht sein, um aus mindestens einer Eingangsgröße mindestens eine Ausgangsgröße bestimmen, wobei die Bestimmung von der temperaturspezifischen Eigenschaft abhängig ist, wobei die Ausgangsgröße eine temperaturunabhängige Größe sein kann. Dies ermöglicht in vorteilhafter Weise eine genaue Bestimmung der Ausgangsgröße.

Ist z.B. die temperaturspezifische Eigenschaft ein Widerstand, so kann die Ausgangsspannung eines Spannungsteilers aus zumindest zwei Widerständen und der Eingangsspannung bestimmt werden, wobei die Widerstände abhängig von den temperaturspezifischen Eigenschaften der Widerstände bezogen auf eine vorbestimmte Referenztemperatur bestimmt werden. Soll z.B. eine temperaturunabhängige Batterieausgangsspannung (Ausgangsgröße) aus einer an einem Widerstand eines Spannungsteilers, der aus einer Reihenschaltung aus mindestens zwei Widerständen besteht, bei einer aktuellen Temperatur anliegenden Spannung (Eingangsgröße) bestimmt werden, so können die hierzu erforderlichen Widerstandswerte bezogen auf eine vorbestimmte Referenztemperatur, die von der aktuellen Temperatur verschieden sein kann, und dann in Abhängigkeit dieser Werte die Batterieausgangsspannung bestimmt werden.

Ist die temperaturspezifische Eigenschaft ein Widerstand, so kann ein Widerstandskorrekturfaktor als Produkt des Widerstandswerts bei der Referenztemperatur und dem Steigungswert bestimmt werden. Dann kann für eine aktuelle Temperatur in bekannter Weise ein Widerstandswert (bezogen auf die aktuelle Temperatur) in Abhängigkeit von Offset-Wert und Steigungswert bestimmt werden. Dann kann zur Bestimmung des Widerstands bezogen auf die vorbestimmte Referenztemperatur das Produkt aus Widerstandskorrekturfaktor und der Differenz zwischen aktueller Temperatur und Referenztemperatur von diesem Wert abgezogen werden. Die Referenztemperatur kann beispielsweise 25 °C betragen.

Mit anderen Worten wird also die Eigenschaft des ersten elektrischen Bauelements bei mindestens zwei verschiedene Temperaturen im Produktionsverfahren bestimmt. Der mindestens eine Korrekturparameter ermöglicht in vorteilhafter Weise eine Korrektur eines Nominalwerts der mindestens einen Eigenschaft für Temperaturen, die von der vorhergehend erläuterten Referenztemperatur abweichen. Der mindestens eine Korrekturparameter kann dann gespeichert werden, insbesondere in bauelementbezogener Weise.

Das Verfahren ermöglicht in vorteilhafter Weise die genaue Bestimmung mindestens eines Korrekturparameters für mindestens eine temperaturabhängige Eigenschaft des ersten elektrischen Bauelements und ist einfach in ein Produktionsverfahren integrierbar. Die Bestimmung kann insbesondere als so genannte Zweipunkt-Kalibrierung bezeichnet werden. Hierzu wird eine zur Durchführung eines Produktionsschritts ohnehin notwendige Temperaturveränderung genutzt, um eine erste temperaturspezifische Eigenschaft für die Bestimmung des Produktionsparameters zu nutzen. Weiter wird für die Bestimmung einer weiteren temperaturspezifischen Eigenschaft ebenfalls eine Produktionstemperatur genutzt, die sich ohnehin während des Produktionsverfahrens einstellt.

In einer bevorzugten Ausführungsform ist das elektrische Bauelement ein Widerstandselement. Dieses Widerstandselement kann insbesondere Bestandteil eines Widerstands- bzw. Spannungsteilers sein. Das Widerstandselement kann insbesondere zur Bestimmung einer Hochvolt-Gleichspannung, einer Phasenstrommessung oder einer Rotorspannungsmessung in einem elektrischen Fahrzeug dienen. Im Falle des Widerstandselements ist die mindestens eine Eigenschaft der Widerstandswert des Widerstandselements für verschiedene Temperaturen. Hierdurch ergibt sich in vorteilhafter Weise eine möglichst genaue Bestimmung des Widerstandswerts, was dann wiederum auch eine genaue Bestimmung der Hochvolt-Gleichspannung, der Phasenströme und/oder der Rotorspannung ermöglicht. Dies wiederum führt zu einem verbesserten Betrieb des elektrischen Fahrzeugs.

In einer weiteren Ausführungsform ist das Produkt eine Leiterplatte (PCB). In diesem Fall kann das Produktionsverfahren ein PCBA-Verfahren sein. Insbesondere kann die Leiterplatte mit dem mindestens einen elektrischen Bauelement bestückt werden. Dieses kann also auf der Leiterplatte, insbesondere einer Seite der Leiterplatte, montiert werden. Hierdurch ergibt sich in vorteilhafter Weise, dass das Verfahren zur Bestimmung des mindestens einen Korrekturparameters in einfacher Weise in ein Verfahren zur Herstellung einer Leiterplatte integriert werden kann.

In einer weiteren Ausführungsform wird in zumindest einem weiteren Produktionsschritt des Produktionsverfahrens eine Temperatur des ersten elektrischen Bauelements und eines weiteren elektrischen Bauelements, welches in dem mehrschrittigen Produktionsverfahren nach dem ersten elektrischen Bauelement verbaut wird, auf eine zweite Produktionstemperatur verändert. In diesem Fall wird also ein weitere elektrische Bauelement in dem mehrschrittigen Produktionsverfahren in oder an dem Produkt verbaut, insbesondere nach dem ersten elektrischen Bauelement. Die Produktionstemperatur kann hierbei von der ersten Produktionstemperatur und/oder der weiteren Produktionstemperatur verschieden sein.

In diesem Fall umfasst das Verfahren weiter ein Bestimmen der mindestens einen Eigenschaft des ersten elektrischen Bauelements nach Erreichen der zweiten Produktionstemperatur als zweite temperaturspezifische Eigenschaft und das Bestimmen des Korrekturparameters in Abhängigkeit der temperaturspezifischen Eigenschaften des ersten elektrischen Bauelements. Mit anderen Worten kann nun der Korrekturparameter in Abhängigkeit von mindestens drei voneinander verschiedenen temperaturspezifischen Eigenschaften bestimmt werden.

Alternativ oder kumulativ erfolgt ein Bestimmen der mindestens einen Eigenschaft des weiteren elektrischen Bauelements nach Erreichen der zweiten Produktionstemperatur als erste temperaturspezifische Eigenschaft des weiteren elektrischen Bauelements und ein Bestimmen der mindestens einen Eigenschaft des weiteren elektrischen Bauelements bei mindestens einer weiteren Produktionstemperatur, die von der zweiten Produktionstemperatur verschieden ist, als weitere temperaturspezifische Eigenschaft des weiteren elektrischen Bauelements. Die temperaturspezifischen Eigenschaften des weiteren Bauelements können gespeichert werden, beispielsweise in der vorhergehend erläuterten Speichereinrichtung. In diesem Szenario kann also auch ein Korrekturparameter für mindestens ein weiteres Bauelement in genauer und gut in das Produktionsverfahren integrierter Weise bestimmt werden. Insbesondere kann eine Temperaturänderung in einem weiteren Produktionsschritt genutzt werden, um eine der zumindest zwei vorgesehenen temperaturspezifischen Eigenschaften zu bestimmen. Diese Ausführungsform ist insbesondere dann von Vorteil, wenn verschiedene Bauelemente nacheinander in/an dem Produkt verbaut werden und für jedes der Bauelemente der mindestens eine Korrekturparameter bestimmt werden soll.

In einer weiteren Ausführungsform ist der Produktionsschritt, in dem die Temperatur verändert wird, ein Lötschritt. Insbesondere kann das Löten erfolgen, indem das nicht fertiggestellte Produkt mit dem ersten und/oder dem weiteren elektrischen Bauelement in einem Lötofen angeordnet wird, um das/die elektrische(n) Bauelement(e) z.B. mit einer Leiterplatte zu verlöten.

Hierdurch ergibt sich in vorteilhafter Weise, dass die beim ohnehin stattfindenden Lötschritt zur Montage eines elektrischen Bauelements stattfindende Temperaturerhöhung genutzt wird, um den Korrekturparameter zu bestimmen.

In einer weiteren Ausführungsform erfolgt das Bestimmen der mindestens einen Eigenschaft durch ein ICT (In-Circuit-Test). Ein solcher ICT ist ein Prüfverfahren, um die korrekte Funktion elektronischer Baugruppen nachzuweisen. Im Rahmen des ICT werden in der Regel ohnehin Eigenschaften von elektrischen Bauelementen bestimmt und mit Soll-Werten verglichen. Somit kann in vorteilhafter Weise die ohnehin stattfindende Bestimmung genutzt werden, um auch den mindestens einen Korrekturparameter zu bestimmen.

In einer weiteren Ausführungsform erfolgt die Veränderung der Temperatur auf die weitere Produktionstemperatur durch eine aktive Kühlung oder ein aktives Heizen. Hierbei wird, wie vorhergehend erläutert, unter Energieverbrauch thermische Energie zu- oder abgeführt, was bei einer passiven Kühlung oder einem passiven Aufheizen z.B. auf eine Umgebungstemperatur nicht der Fall ist. Hierdurch kann in vorteilhafter Weise eine Zeitdauer zur Bestimmung des Korrekturparameters beschleunigt werden bzw. die zum Erreichen der Temperatur benötigte Zeitdauer an die gewünschte Gesamtproduktionszeit angepasst werden.

In einer weiteren Ausführungsform wird vor dem ersten Produktionsschritt eine erste Menge von elektrischen Bauelementen, für die jeweils ein Korrekturparameter bestimmt wird, auf einer ersten Seite einer Leiterplatte angeordnet. Die erste Menge kann z.B. mindestens das erste elektrische Bauelement umfassen. In diesem Fall kann dann die Leiterplatte mit den darauf angeordneten Bauelementen in einen Lötofen zur Durchführung eines Lötschrittes transportiert werden. Dieser Lötschritt kann genutzt werden, um eine erste temperaturspezifische Eigenschaft der elektrischen Bauelemente der ersten Menge zu bestimmen. Somit werden also die ersten temperaturspezfischen Eigenschaften nur für elektrische Bauelemente der ersten Menge bestimmt. Durch die Anordnung von elektrischen Bauelementen auf einer erste Seite der Leiterplatte ergibt sich in vorteilhafter Weise, dass eine gewünschte Temperaturveränderung für all diese elektrischen Bauelemente der ersten Menge in zuverlässiger Weise eintritt, insbesondere falls sich die Temperaturänderung nicht oder nicht im gleichen Maße auf die andere Seite der Leiterplatte und dort angeordnete elektrische Bauelemente auswirkt. Somit wird die Zuverlässigkeit und Genauigkeit bei der Bestimmung des mindestens einen Korrekturparameters erhöht.

In einer weiteren Ausführungsform wird vor dem zweiten Produktionsschritt eine weitere Menge von elektrischen Bauelementen, für die jeweils ein Korrekturparameter bestimmt wird, auf einer weiteren Seite der Leiterplatte angeordnet. Die weitere Menge kann z.B. mindestens das weitere elektrische Bauelement umfassen. In diesem Fall kann dann die Leiterplatte mit den darauf angeordneten Bauelementen in einen (weiteren) Lötofen zur Durchführung eines weiteren Lötschrittes transportiert werden. Dieser Lötschritt kann genutzt werden, um eine erste temperaturspezifische Eigenschaft der elektrischen Bauelemente der weiteren Menge zu bestimmen. Somit werden also die ersten temperaturspezifischen Eigenschaften für elektrische Bauelemente der weiteren Menge bestimmt, insbesondere nur für diese elektrischen Elemente. Somit ergibt sich in vorteilhafter Weise, dass eine gewünschte Temperaturveränderung für all diese elektrischen Bauelemente der weiteren Menge in zuverlässiger Weise eintritt, insbesondere falls sich die Temperaturänderung nicht oder nicht im gleichen Maße auf die erste Seite der Leiterplatte und dort angeordnete elektrische Bauelemente auswirkt. Dies erhöht die Genauigkeit bei der Bestimmung der Korrekturparameter für die elektrischen Bauelemente der weiteren Menge.

Es ist aber, wie vorhergehend erläutert, möglich, dass gleichzeitig zweite temperaturspezifische Eigenschaften der elektrischen Bauelemente der ersten Menge bestimmt werden.

Weiter vorgeschlagen wird eine Vorrichtung zur Bestimmung mindestens eines Korrekturparameters für mindestens eine temperaturabhängige Eigenschaft mindestens eines ersten elektrischen Bauelements, welches in einem mehrschrittigen Produktionsverfahren eines Produkts verbaut wird. In zumindest einem ersten Produktionsschritt des Produktionsverfahrens wird eine Temperatur des ersten elektrischen Bauelements auf eine erste Produktionstemperatur verändert.

Die Vorrichtung umfasst mindestens eine Auswerteeinrichtung und Mittel zur Bestimmung der mindestens einen Eigenschaft des ersten elektrischen Bauelements nach Erreichen der ersten Produktionstemperatur als erste temperaturspezifische Eigenschaft des ersten elektrischen Bauelements sowie Mittel zur Bestimmung der mindestens einen Eigenschaft des ersten elektrischen Bauelements bei einer weiteren Produktionstemperatur, die von der ersten Produktionstemperatur verschieden ist, als weitere temperaturspezifische Eigenschaft des ersten elektrischen Bauelements. Weiter wird mittels der Auswerteeinrichtung der Korrekturparameter in Abhängigkeit der temperaturspezifischen Eigenschaften des ersten elektrischen Bauelements bestimmt. Die Vorrichtung ist somit konfiguriert, ein Verfahren gemäß einer der in dieser Offenbarung beschriebenen Ausführungsform mit den bereits erläuterten technischen Vorteilen durchzuführen.

Die Vorrichtung kann weiter mindestens eine Speichereinrichtung zur Speicherung von temperaturspezifischen Eigenschaften, insbesondere in bauelementbezogener Weise, umfassen. Ebenfalls kann die Vorrichtung eine Speichereinrichtung zur Speicherung mindestens eines Korrekturparameters, insbesondere ebenfalls in bauelementbezogener Weise, umfassen. Selbstverständlich kann die Vorrichtung auch Mittel zur Bestimmung der mindestens einen Eigenschaft eines weiteren elektrischen Bauelements umfassen. Weiter kann die Vorrichtung zur Veränderung der Temperatur umfassen.

Die Vorrichtung kann hierbei in eine Produktionsvorrichtung integriert werden, wobei die Produktionsvorrichtung als Produktionsstraße ausgebildet sein oder eine solche umfassen kann. Somit wird auch eine Produktionsvorrichtung beschrieben, die eine Vorrichtung gemäß einer der in dieser Offenbarung beschriebenen Ausführungsformen umfasst. Die Produktionsvorrichtung kann Einrichtungen zur Durchführung von Produktionsschritten umfassen, beispielsweise einen Lötofen.

Die Erfindung wird anhand von Ausführungsbeispielen näher erläutert. Die Figuren zeigen:
- Fig. 1: ein schematisches Flussdiagramm eines erfindungsgemäßen Verfahrens in einer ersten Ausführungsform,
- Fig. 2: ein schematisches Flussdiagramm eines erfindungsgemäßen Verfahrens in einer weiteren Ausführungsform und
- Fig. 3: ein schematisches Blockschaltbild einer erfindungsgemäßen Vorrichtung.

Nachfolgend bezeichnen gleiche Bezugszeichen Elemente mit gleichen oder ähnlichen technischen Merkmalen.

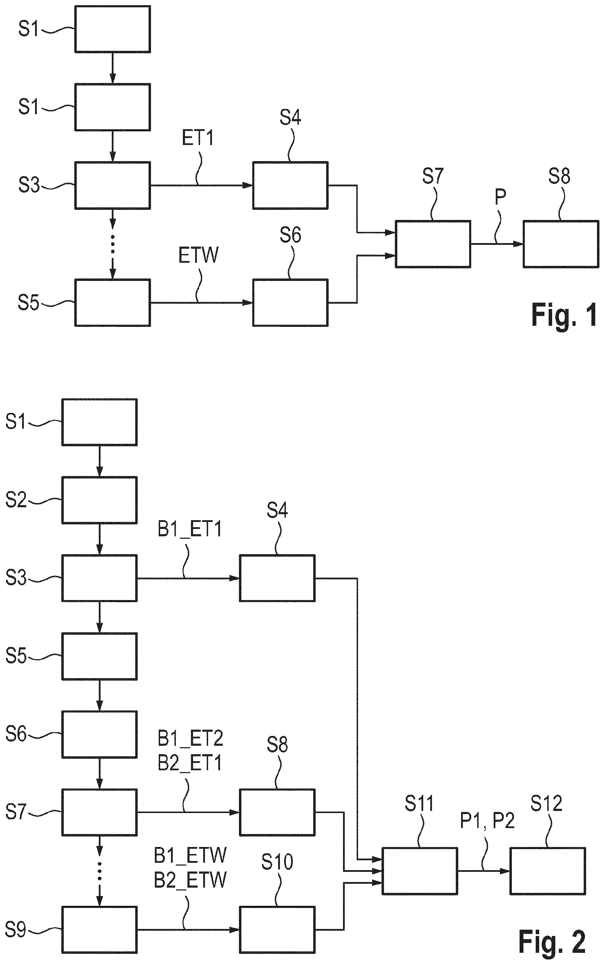

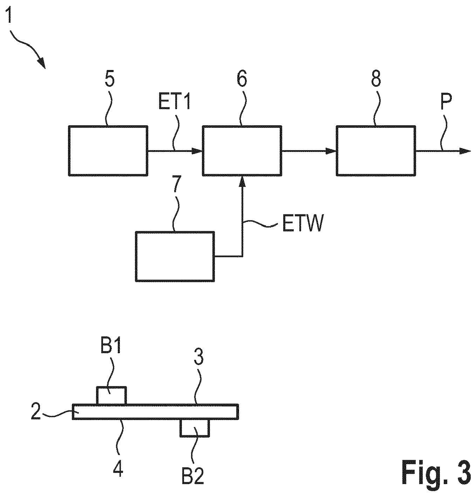

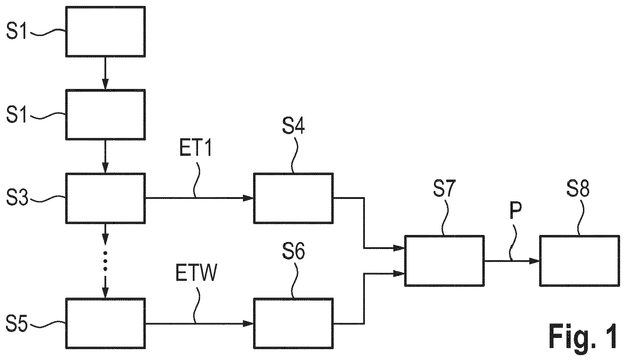

Fig. 1 zeigt ein schematisches Flussdiagramm eines erfindungsgemäßen Verfahrens in einer ersten Ausführungsform. Das Verfahren ist hierbei in ein Produktionsverfahren eines Produkts integriert. In einem ersten Schritt S1 des Produktionsverfahrens wird mindestens ein erstes elektrisches Bauelement B1 (siehe Fig. 3) in dem Produkt verbaut. Beispielsweise kann das erste elektrische Bauelement B1 ein Widerstandselement sein, welches auf einer ersten Seite 3 einer Leiterplatte 2 angeordnet und auf dieser Seite 3 mit der Leiterplatte 2 verlötet wird.

In einem zweiten Schritt S2 des Produktionsverfahrens wird eine Temperatur des ersten elektrischen Bauelements B1 auf eine erste Produktionstemperatur verändert. Hierzu kann beispielsweise die Leiterplatte 2 mit dem darauf angeordneten ersten elektrischen Bauelement B1 in einen Lötofen eingebracht werden, um einen Lötprozess auf der ersten Seite 3 durchzuführen. Zum Löten kann die Temperatur von einer Ausgangstemperatur, z.B. einer Umgebungstemperatur, auf eine höhere Zieltemperatur, z.B. 105 °C, erhöht werden. In einem dritten Schritt S3, der kein Produktionsschritt ist bzw. sein muss, wird nach dem Erreichen dieser ersten Produktionstemperatur eine Eigenschaft des ersten elektrischen Bauelements B1 als erste temperaturspezifische Eigenschaft ET1 bestimmt und in einem vierten Schritt S4 gespeichert.

In einem fünften Schritt S5, der wiederum nicht notwendiger Weise ein Produktionsschritt sein muss, wird die mindestens eine Eigenschaft des ersten elektrischen Bauelements B1 bei einer weiteren Produktionstemperatur bestimmt, die von der ersten Produktionstemperatur verschieden ist, und als weitere temperaturspezifische Eigenschaft ETW in einem sechsten Schritt S6 gespeichert. Die weitere Produktionstemperatur kann insbesondere eine Umgebungstemperatur sein, dies ist jedoch nicht zwingend. Das Bestimmung der weiteren temperaturspezifischen Eigenschaft kann zeitlich vor oder zeitlich nach dem Bestimmen der ersten temperaturspezifischen Eigenschaft erfolgen.

In einem siebten Schritt S7 wird mindestens ein Korrekturparameter P in Abhängigkeit der temperaturspezifischen Eigenschaften ET1, ETW des ersten elektrischen Bauelements B1 bestimmt, beispielsweise ein Offsetwert oder ein Steigungswert bzw. Korrekturfaktoren für diese Werte. Dieser Parameter P kann ebenfalls gespeichert werden.

In einem achten, optionalen Schritt S8 erfolgt ein Prüfen des mindestens einen Korrekturparameters P. So kann z.B. geprüft werden, ob der bestimmte Korrekturparameterwert P innerhalb eines zulässigen Wertebereichs liegt.

Hiernach kann der bestimmte Korrekturparameter P in bauelementbezogener Weise abrufbar gespeichert werden, um dann für eine genaue Bestimmung der Eigenschaft bei verschiedenen Temperaturen berücksichtigt zu werden.

Die in Fig. 1 dargestellten Schritte S1, S2, S3, S4, S5, S6, S7, S8 sind nicht alle notwendigerweise Produktionsschritte bzw. Schritte des vorgeschlagenen Verfahrens. Auch die in Fig. 1 dargestellte Reihenfolge dient nur zur Veranschaulichung, es ist auch eine andere Reihenfolge der dargestellten Schritte vorstellbar.

Fig. 2 zeigt ein schematisches Flussdiagramm eines erfindungsgemäßen Verfahrens in einer weiteren Ausführungsform. Hierbei entsprechen der erste Schritt S1, der zweite Schritt S2, der dritte Schritt S3 und der vierte Schritt S4 den entsprechenden Schritten S1,... ,S4 der in Fig. 1 dargestellten Ausführungsform. Im Unterschied zu der in Fig. 1 dargestellten Ausführungsform erfolgt in einem fünften Schritt S5, der ein Produktionsschritt sein kann, die Anordnung eines weiteren elektrischen Bauelements B2 (siehe Fig. 3) auf einer der ersten Seite 3 gegenüberliegenden Seite 4 der Leiterplatte2 . In einem sechsten Schritt S6, der ein Produktionsschritt sein kann, wird die Leiterplatte 2 in einen Lötofen eingebracht, um das weitere elektrische Bauelement B2 mit der Leiterplatte 2 zu verlöten. Die Produktionstemperatur kann hierfür von einer Ausgangstemperatur, z.B. einer Umgebungstemperatur, auf eine zweite Produktionstemperatur verändert werden, beispielsweise 105 °C, aber auch einen davon verschiedenen Wert. Nach Erreichen dieser zweiten Produktionstemperatur kann in einem siebten Schritt S7 die Eigenschaft des ersten elektrischen Bauelements B1 bestimmt und als zweite temperaturspezifische Eigenschaft B1_ET2 in einem achten Schritt S8 gespeichert werden. Weiter kann im siebten Schritt S7 eine Eigenschaft des weiteren elektrischen Bauelements B2 nach Erreichen der zweiten Produktionstemperatur als erste temperaturspezifische Eigenschaft B2_ET1 des weiteren elektrischen Bauelements B2 bestimmt werden und ebenfalls im achten Schritt S8 gespeichert werden.

In einem neunten Schritt S9 erfolgt ein Bestimmen der Eigenschaft des ersten elektrischen Bauelements bei einer weiteren Produktionstemperatur, die von der ersten und der zweiten Produktionstemperatur verschieden ist, als weitere temperaturspezifische Eigenschaft B1_ETW des ersten elektrischen Bauelements B1 sowie ein Bestimmen der Eigenschaft des weiteren elektrischen Bauelements B2 als weitere temperaturspezifische Eigenschaft B2_ETW des weiteren elektrischen Bauelements B2. Diese werden in einem zehnten Schritt S10 gespeichert, wobei in einem elften Schritt S11 dann bauelementspezifische Korrekturparameter P1, P2 bestimmt werden und in einem optionalen zwölften Schritt S12 überprüft werden.

Fig. 3 zeigt ein schematisches Blockschaltbild einer erfindungsgemäßen Vorrichtung 1 zur Bestimmung mindestens eines Korrekturparameters P, P1, P2 (siehe Fig. 1 und Fig. 2) für mindestens eine temperaturabhängige Eigenschaft mindestens eines ersten elektrischen Bauelements B1. Dargestellt ist eine Leiterplatte 2 mit einer ersten Seite 3 und einer zweiten Seite 4, die der ersten Seite 3 gegenüberliegt. Die erste Seite 3 dient zur Anordnung des ersten elektrischen Bauelements B1 und die zweite Seite 4 zur Anordnung eines weiteren elektrischen Bauelements B2. Die Vorrichtung umfasst ein Mittel 5 zur Bestimmung mindestens einer Eigenschaft des ersten elektrischen Bauelements B1 nach Erreichen einer ersten Produktionstemperatur als erste temperaturspezifische Eigenschaft B1_ET1 des ersten elektrischen Bauelements B1. Diese kann in einer Speichereinrichtung 6 der Vorrichtung 1 gespeichert werden. Ebenfalls umfasst die Vorrichtung 1 Mittel 7 zum Bestimmen einer Eigenschaft des ersten elektrischen Bauelements B2 nach Erreichen einer weiteren Produktionstemperatur, die von der ersten Produktionstemperatur verschieden ist, als weitere temperaturspezifische Eigenschaft B1_ETW des ersten elektrischen Bauelements B1, wobei diese Eigenschaft ebenfalls in der Speichereinrichtung 6 gespeichert werden kann. Eine Auswerteeinrichtung 8 der Vorrichtung 1 kann dann in Abhängigkeit dieser temperaturspezifischen Eigenschaften ET1, ETW einen Korrekturparameter P für die Eigenschaft des ersten elektrischen Bauelements B1 bestimmen.

Ebenfalls kann die Vorrichtung nicht dargestellte Mittel zur Bestimmung von temperaturspezifischen Eigenschaften B2_ET1, B2_ETW des weiteren elektrischen Bauelements 2 bei einer zweiten und bei der weiteren Produktionstemperatur umfassen, wobei dann ein Korrekturparameter P2 für die Eigenschaft des weiteren elektrischen Bauelements B2 bestimmt werden kann.

### Bezugszeichenliste

- S1, ..., S12: Schritt
- ET1: erste temperaturspezifische Eigenschaft
- ETW: weitere temperaturspezifische Eigenschaft
- P: Korrekturparameter
- B1_ET1: erste temperaturspezifische Eigenschaft des ersten elektrischen Bauelements
- B1_ET2: zweite temperaturspezifische Eigenschaft des ersten elektrischen Bauelements
- B1_ETW: weitere temperaturspezifische Eigenschaft des ersten elektrischen Bauelements
- B2_ET1: erste temperaturspezifische Eigenschaft des weiteren elektrischen Bauelements
- B2_ETW: weitere temperaturspezifische Eigenschaft des weiteren elektrischen Bauelements
- P1: Korrekturparameter des ersten elektrischen Bauelements
- P2: Korrekturparameter des weiteren elektrischen Bauelements
- 1: Vorrichtung
- 2: Leiterplatte
- 3: erste Seite
- 4: zweite Seite
- 5: Mittel zur Bestimmung
- 6: Speichereinrichtung
- 7: Mittel zur Bestimmung
- 8: Auswerteeinrichtung
- B1: erstes elektrisches Bauelement
- B2: weiteres elektrisches Bauelement

## Patentansprüche

1. Verfahren zur Bestimmung mindestens eines Korrekturparameters (P, P1) für mindestens eine temperaturabhängige Eigenschaft mindestens eines ersten elektrischen Bauelements (B1), welches in einem mehrschrittigen Produktionsverfahren eines Produkts verbaut wird, wobei in zumindest einem ersten Produktionsschritt des Produktionsverfahrens eine Temperatur des ersten elektrischen Bauelements (B1) auf eine erste Produktionstemperatur verändert wird, umfassend mindestens:
- Bestimmen der mindestens einen Eigenschaft des ersten elektrischen Bauelements (B1) nach Erreichen der ersten Produktionstemperatur als erste temperaturspezifische Eigenschaft (ET1, B1_ET1) des ersten elektrischen Bauelements (B1),
- Bestimmen der mindestens einen Eigenschaft des ersten elektrischen Bauelements (B1) bei mindestens einer weiteren Produktionstemperatur, die von der ersten Produktionstemperatur verschieden ist, als weitere temperaturspezifische Eigenschaft (ETW, B1_ETW) des ersten elektrischen Bauelements (B1),
- Bestimmen des mindestens einen Korrekturparameters (P, P1) in Abhängigkeit der temperaturspezifischen Eigenschaften (ET1, B1_ET1, ETW, B1_ETW) des ersten elektrischen Bauelements (B1).

2. Verfahren nach Anspruch 1, **dadurch gekennzeichnet, dass** das erste elektrische Bauelement (B1) ein Widerstandselement ist.

3. Verfahren nach einem der vorangegangenen Ansprüche, **dadurch gekennzeichnet, dass** das Produkt eine Leiterplatte (2) ist.

4. Verfahren nach einem der vorangegangenen Ansprüche, **dadurch gekennzeichnet, dass** in zumindest einem weiteren Produktionsschritt des Produktionsverfahrens eine Temperatur des ersten elektrischen Bauelements (B1) und eines weiteren elektrischen Bauelements (B2), welches in dem mehrschrittigen Produktionsverfahren nach dem ersten elektrischen Bauelement (B1) verbaut wird, auf eine zweite Produktionstemperatur verändert wird und das Verfahren weiter umfasst:
- Bestimmen der mindestens einen Eigenschaft des ersten elektrischen Bauelements (B1) nach Erreichen der zweiten Produktionstemperatur als zweite temperaturspezifische Eigenschaft (B1_ET2) des ersten elektrischen Bauelements (B1),
- Bestimmen des Korrekturparameters (P1) für das erste elektrischen Bauelement (B1) in Abhängigkeit der temperaturspezifischen Eigenschaften des ersten elektrischen Bauelements (B1_ET1, B1_ET2, B1_ETW)
und/oder
- Bestimmen der mindestens einen Eigenschaft des weiteren elektrischen Bauelements (B2) nach Erreichen der zweiten Produktionstemperatur als erste temperaturspezifische Eigenschaft (B2_ET1) des weiteren elektrischen Bauelements (B2),
- Bestimmen der mindestens einen Eigenschaft des weiteren elektrischen Bauelements (B2) bei mindestens einer weiteren Produktionstemperatur, die von der zweiten Produktionstemperatur verschieden ist, als weitere temperaturspezifische Eigenschaft (B2_ETW) des weiteren elektrischen Bauelements (B2),
- Bestimmen des mindestens einen Korrekturparameters (P2) für das weitere elektrische Bauelement (B2) in Abhängigkeit der temperaturspezifischen Eigenschaften (B2_ET1, B2_ETW) des weiteren elektrischen Bauelements (B2).

5. Verfahren nach einem der vorangegangenen Ansprüche, **dadurch gekennzeichnet, dass** der Produktionsschritt, in dem die Temperatur verändert wird, ein Lötschritt ist.

6. Verfahren nach einem der vorangegangenen Ansprüche, **dadurch gekennzeichnet, dass** das Bestimmen der mindestens einen Eigenschaft durch ein ICT erfolgt.

7. Verfahren nach einem der vorangegangenen Ansprüche, **dadurch gekennzeichnet, dass** die Veränderung der Temperatur auf die weitere Produktionstemperatur durch eine aktive Kühlung oder ein aktives Heizen erfolgt.

8. Verfahren nach einem der vorangegangenen Ansprüche, **dadurch gekennzeichnet, dass** vor dem ersten Produktionsschritt eine erste Menge von elektrischen Bauelementen (B1), für die jeweils ein Korrekturparameter bestimmt wird, auf einer ersten Seite (3) einer Leiterplatte (2) angeordnet wird.

9. Verfahren nach Anspruch 8, der zumindest auf Anspruch 4 zurückbezogen ist, **dadurch gekennzeichnet, dass** vor dem zweiten Produktionsschritt eine weitere Menge von elektrischen Bauelementen (B2), für die jeweils ein Korrekturparameter bestimmt wird, auf einer weiteren Seite (4) der Leiterplatte (2) angeordnet wird.

10. Vorrichtung zur Bestimmung mindestens eines Korrekturparameters (P, P1) für mindestens eine temperaturabhängige Eigenschaft mindestens eines ersten elektrischen Bauelements (B1), welches in einem mehrschrittigen Produktionsverfahren eines Produkts verbaut wird, wobei in zumindest einem ersten Produktionsschritt des Produktionsverfahrens eine Temperatur des ersten elektrischen Bauelements (B1) auf eine erste Produktionstemperatur verändert wird, umfassend mindestens eine Auswerteeinrichtung (8) und Mittel (5) zur Bestimmung der mindestens einen Eigenschaft des ersten elektrischen Bauelements (B1) nach Erreichen der ersten Produktionstemperatur als erste temperaturspezifische Eigenschaft (ET1, B1_ET1) des ersten elektrischen Bauelements (B1), Mittel (7) zur Bestimmung der mindestens einen Eigenschaft des ersten elektrischen Bauelements (B1) bei einer weiteren Produktionstemperatur, die von der ersten Produktionstemperatur verschieden ist, als weitere temperaturspezifische Eigenschaft (ETW, B1_ETW) des ersten elektrischen Bauelements (B1), wobei mittels der Auswerteeinrichtung (8) der Korrekturparameter (P, P1) in Abhängigkeit der temperaturspezifischen Eigenschaften (ET1, B1_ET1, ETW, B1_ETW) des ersten elektrischen Bauelements (B1) bestimmt wird.
